# EUROPÄISCHE PATENTANMELDUNG

(11) **EP 1 113 282 A2**
(43) Veröffentlichungstag der Anmeldung: **04.07.2001**
(21) Anmeldenummer: 00126891.1
(22) Anmeldetag: 07.12.2000
(51) Int. Cl.: G01R 31/3193

(54) **Anordnung zum Testen einer Vielzahl von Halbleiterchips**

(30) Priorität: 23.12.1999 DE 19962677
(71) Anmelder: Infineon Technologies AG, 81669 München (DE)
(72) Erfinder: Feurle, Robert, 85579 Neubiberg (DE); Savignac, Dominique, 85737 Ismaning (DE)
(74) Vertreter: MÜLLER & HOFFMANN Patentanwälte

(57) **Zusammenfassung**

Die Erfindung betrifft eine Anordnung zum Testen einer Vielzahl von Halbleiterchips hinsichtlich kritischer Parameter, bei der auf den Halbleiterchips (1) eines Halbleiterwafers zusätzlich wenigstens ein Optionspad (4) vorgesehen ist, mit dem ein Testprogramm zum Aussondern derjenigen Halbleiterchips (1) anlegbar ist, die nicht vorgegebenen Forderungen für kritische Parameter entsprechen.

## Beschreibung

Die vorliegende Erfindung betrifft eine Anordnung zum Testen einer Vielzahl von Halbleiterchips hinsichtlich kritischer Parameter, mittels der Halbleiterchips, die nicht vorgegebene Forderungen für diese kritischen Parameter erfüllen, aussonderbar sind.

Halbleiterchips müssen eine Vielzahl von Tests durchlaufen, bevor sie an Kunden ausgeliefert werden können. Bei diesen Tests werden die Halbleiterchips hinsichtlich verschiedener Parameter untersucht, zu denen bei beispielsweise SDRAMs (DRAMs mit synchroner Taktsteuerung) sogenannte Timingparameter gehören, wie insbesondere ein sogenannter Tdpl-Test: bei diesem wird nach Einschreiben von Daten in eine Speicherzelle und Herunterfahren des Potentials von deren Wortleitung untersucht, ob und wie lange diese Speicherzelle die darin gespeicherten Daten hält.

Abhängig vom Hersteller eines Halbleiterwafers für den Halbleiterchip können sich bei der Überprüfung der einzelnen Halbleiterchips für diese Timingparameter unterschiedliche Werte ergeben, die jeweils herstellerabhängig kürzer oder länger sein können.

Um in Anbetracht dieser Situation dennoch eine gleichmäßige Qualität garantieren zu können, werden bisher Design und Testprogramm für Halbleiterchips hinsichtlich solcher Timingparameter jeweils für den ungünstigsten Fall ("Worst Case Fall") ausgelegt, um so Kunden mit Halbleiterchips beliefern zu können, die auf jeden Fall den gestellten Anforderungen hinsichtlich der Timingparameter entsprechen.

Bisher werden also Halbleiterchips hinsichtlich kritischer Timingparameter jeweils einzeln gebondet und mittels eines Testgerätes überprüft, ob diese Halbleiterchips in bezug auf die Timingparameter den gestellten Anforderungen entsprechen. Ein derartiges Vorgehen ist aber relativ aufwendig.

Es ist daher Aufgabe der vorliegenden Erfindung, eine Anordnung zum Testen einer Vielzahl von Halbleiterchips zu schaffen, mit der bereits auf Waferebene die Möglichkeit geboten wird, die Halbleiterchips in bezug auf unterschiedliche Timingparameter zu untersuchen, damit festgestellt werden kann, ob der jeweilige Halbleiterchip die an ihn gestellten Anforderungen erfüllt.

Diese Aufgabe wird bei einer Anordnung der eingangs genannten Art erfindungsgemäß dadurch gelöst, daß die Halbleiterchips eines Halbleiterwafers jeweils wenigstens ein Optionspad haben, über das an die Halbleiterchips auf Waferebene ein Testprogramm zum Aussondern derjenigen Halbleiterchips, die nicht die vorgegebenen Forderungen für die kritischen Parameter erfüllen, anlegbar ist.

Bei der erfindungsgemäßen Anordnung wird also bereits auf Waferebene ohne großen Aufwand geprüft, ob der jeweilige Halbleiterchip die an ihn gestellten Anforderungen in bezug auf die kritischen Timingparameter erfüllt. Mit anderen Worten, es kann so für jeden Halbleiterchip die für ihn zutreffende Option hinsichtlich der Timingparameter bereits auf Waferebene festgelegt werden.

Ein bevorzugtes Beispiel für die kritischen Parameter sind insbesondere Timingparameter, die die Daten-Haltezeit in Speicherzellen des Halbleiterchips betreffen.

Die erfindungsgemäße Anordnung eröffnet insbesondere die Möglichkeit, vor einer festen Einstellung von kritischen Parametern überprüfen zu können, ob dies auch ohne Ausbeuteverlust in einem Test der Halbleiterchips möglich ist.

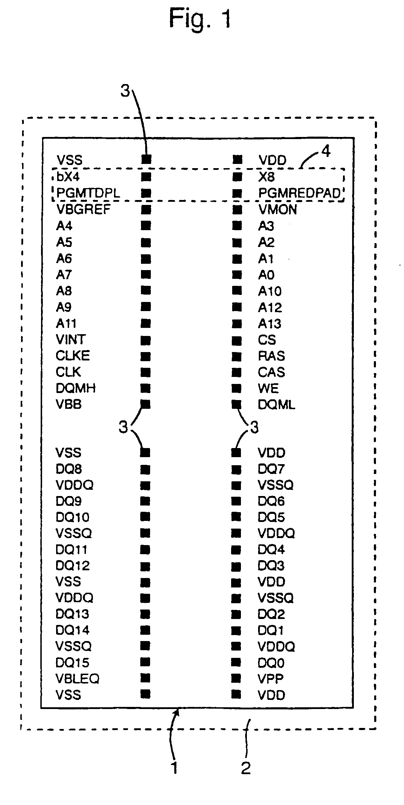

Nachfolgend wird die Erfindung anhand der Zeichnung näher erläutert, in deren einziger Figur ein Halbleiterchip in Draufsicht gezeigt ist.

Ein Halbleiterchip 1 mit einem Sägerand bzw. Kerf 2 enthält eine Vielzahl von Pads (Kontaktkissen) 3, über die beispielsweise Versorgungsspannung VDD, VBB, Bezugsspannungen VSS usw. zuführbar und Spannungen von dem Chip abnehmbar sind.

Zusätzlich hat der Halbleiterchip 1 noch Pads bX4, X8, PGMTDPL und PGMREDPAD (umrahmt durch eine Strichlinie 4), über die an den Halbleiterchip 1 bereits auf Waferebene ein Testprogramm angelegt werden kann, mit dem überprüft wird, ob der Halbleiterchip 1 hinsichtlich der kritischen Timingparameter die an ihn gestellten Forderungen erfüllt oder nicht. Solche Halbleiterchips, die diesen Forderungen nicht entsprechen, werden ausgesondert.

Daher eröffnet die vorliegende Erfindung die Möglichkeit, nur solche Halbleiterchips, die tatsächlich die an sie hinsichtlich der kritischen Timingparameter, wie beispielsweise Tdpl, gestellten Forderungen erfüllen, schließlich durch Bonden aufzubauen.

Wesentlich an der vorliegenden Erfindung ist insbesondere die Überprüfung der Halbleiterchips hinsichtlich der kritischen Timingparameter bereits auf Waferebene, wozu gesonderte Pads (vgl. Strichlinie 4) vorgesehen sind, die das Anlegen von Testsignalen an den Halbleiterchip 1 erlauben, welche diesem "suggerieren", er sei in einem gebondeten Testmodus, in welchem er hinsichtlich seiner kritischen Timingparameter überprüft wird. Über die zusätzlich vorgesehenen Optionspads (vgl. Strichlinie 4) eröffnet die erfindungsgemäße Anordnung die Möglichkeit, in dem Halbleiterchip ein Testprogramm ablaufen zu lassen, das diesen hinsichtlich der Timingparameter überprüft.

Die Optionspads (vgl. Strichlinie 4) sind dabei im Inneren des Halbleiterchips 1 so verdrahtet, daß sie ein Testen des Halbleiterchips in bezug auf die Timingparameter erlauben. Mit dem Pad PGMTDPL wird mit "0" (VSS) oder "1" (VCC) der Timing-Parameter DPL beispielsweise eines SDRAM-Halbleiterchips auf 1 clock (Takt) oder 2 clocks umgestellt. Mit einem clock kann der Parameter DPL so schärfer geprüft werden. Hier handelt es sich also um statische Signale.

Die erfindungsgemäße Anordnung eröffnet so die Möglichkeit einer raschen Überprüfung auf Waferebene, ob bestimmte Halbleiterchips die an sie gestellten Anforderungen hinsichtlich besonderer kritischer Timingparameter erfüllen oder nicht.

Im obigen Ausführungsbeispiel werden für die Überprüfung des Halbleiterchips auf kritische Timingparameter vier Pads (vgl. Strichlinie 4) herangezogen. Selbstverständlich ist die Anzahl dieser Pads nicht auf vier begrenzt sondern kann größer oder auch kleiner sein.

## Patentansprüche

1. Anordnung zum Testen einer Vielzahl von Halbleiterchips (1) hinsichtlich kritischer Parameter, mittels der Halbleiterchips (1), die nicht vorgegebene Forderungen für diese kritischen Parameter erfüllen, aussonderbar sind,
**dadurch gekennzeichnet**, daß die Halbleiterchips (1) eines Halbleiterwafers jeweils wenigstens ein Optionspad (4) haben, über das an die Halbleiterchips (1) auf Waferebene ein Testprogramm zum Aussondern derjenigen Halbleiterchips (1), die nicht die vorgegebenen Forderungen für die kritischen Parameter erfüllen, anlegbar ist.

2. Anordnung nach Anspruch 1,
**dadurch gekennzeichnet**, daß die kritischen Parameter Timingparameter sind.

3. Anordnung nach Anspruch 2,
**dadurch gekennzeichnet**, daß der Timingparameter die Daten-Haltezeit in Speicherzellen des Halbleiterchips ist.
